Europäisches Patentamt

European Patent Office

Office européen des brevets

(19)

(11) Publication number: 0 392 109
A2

# (12) EUROPEAN PATENT APPLICATION

(21) Application number: 89305927.9

(22) Date of filing: 12.06.89

(51) Int. Cl.⁵: H01L 23/373, H01L 23/495

(30) Priority: 03.03.89 JP 52705/89

(43) Date of publication of application:
17.10.90 Bulletin 90/42

(84) Designated Contracting States:
CH DE FR GB LI NL

(71) Applicant: SUMITOMO SPECIAL METAL CO.,
LTD.
7-19, 4-chome, Kitahama, Chuo-ku
Osaka City, Osaka(JP)

(72) Inventor: Nakamura, Yasuyuki SUITA
SEISAKUSHO of Sumitomo
Special Metal Co., Ltd. 19-1, 2-chome
Minamisuita Suita City Osaka(JP)
Inventor: Suenaga, Minoru SUITA
SEISAKUSHO of Sumitomo
Special Metal Co., Ltd. 19-1, 2-chome
Minamisuita Suita City Osaka(JP)
Inventor: Kawakami, Makoto SUITA
SEISAKUSHO of Sumitomo
Special Metal Co., Ltd. 19-1, 2-chome
Minamisuita Suita City Osaka(JP)
Inventor: Hirano, Kenji SUITA SEISAKUSHO of
Sumitomo
Special Metal Co., Ltd. 19-1, 2-chome
Minamisuita Suita City Osaka(JP)

(74) Representative: Livsey, Gilbert Charlesworth
Norris et al
HYDE, HEIDE & O'DONNELL 10-12 Priests
Bridge
London SW15 5JE(GB)

(54) Heat-conductive composite material.

(57) A heat-conductive composite (10) usable as a substrate (heat sink) for semiconductor chip thereon or lead frame is provided, which comprises a metal sheet (11) of high thermal expansion at least one main surface of which has been laminated and integrated with a metal sheet (12) of low thermal expansion having a member of through-holes (13), a part of the metal sheet of high thermal expansion being exposed out to the surface (14) of the metal sheet of low thermal expansion through the through-holes thereof. Varying the thickness ratio of the respective constructional metal sheets and the surface area ratio of the exposed metal spots on the main surface, heat-conductive composite materials having any desired thermal expansion coefficient and thermal conductivity can be obtained.

Fig. 2

## HEAT-CONDUCTIVE COMPOSITE AND METHOD OF PREPARING SAME.

### BACKGROUND OF THE INVENTION

#### FIELD OF THE INVENTION

The present invention relates to a heat-conductive composite which is particularly adapted for use in the manufacture of a substrate (heat sink) for mounting a semiconductor chip thereon or a lead frame in semiconductor packages, which has a thermal expansion coefficient in good conformity with that of $Al_2O_3$ or the like ceramic packages as well as with that of semiconductor chips such as silicon, or gallium arsenide, or sealant resins, sealant glass, and which has a high thermal conductivity and therefore can efficiently dissipate the heat generated by semiconductor chips to the external environment.The invention also relates to a method for preparing such a composite.

Specifically, the invention provides a heat-conductive composite comprising a metal sheet of high thermal expansion and a metal sheet of low thermal expansion having a number of through-holes in the direction of the thickness, in which the two sheets are laminated and integrated so that a part of the metal sheet of high thermal expansion is exposed out of or past the metal surface of the sheet of low thermal expansion through the through-holes of the metal sheet of low thermal expansion, whereupon the thickness ratio of the metal sheets and the exposing surface area ratio on the main surface are properly selected so that the laminated material may have a thermal expansion coefficient and thermal conductivity within a rather wide range.

As the heat-conductive composite of the present invention may have any specifically desired properties of thermal expansion coefficient and thermal conductivity within a wide range, it may be adapted for use in the manufacture of the above mentioned substrate (heat sink) or lead frame or it may be arranged between materials of different kinds each having a different thermal expansion coefficient, whereupon peeling or cracking due to difference in thermal expansion coefficient may be alleviated or even prevented. For instance, it may advantageously be used between a Si wafer and a copper stud in a thryristor and it can widely be employed in the field of electronics.

### DESCRIPTION OF THE PRIOR ART

Although the heat-conductive composite of the present invention has a broad range of uses, a heat sink and lead frame in a semiconductor package will be referred to hereinafter as typical examples of the composite. A "semiconductor chip" will be referred to as a "chip" hereinafter.

Recently, with chips of semiconductor packages, especially those in LSI or VLSI for large-scaled (super) computers, development is being directed toward elevation of the degree of integration and acceleration of the operation speed; and as a consequence, the quantity of heat generated by the operation of the devices is becoming extremely large, mainly because of the increase of the electric power consumed in operation. This is to say, the capacity of the chips has become large-scaled and the quantity of heat generated during the operation has also become large.

Accordingly, if the thermal expansion coefficient of the substrate material is significantly different from that of the material of the chip of silicon or gallium arsenide, the chip might inconveniently become peeled off from the substrate or become otherwise damaged or broken.

In view of the the enlargement of the calorific value, as mentioned above, ability to dissipate heat is to be taken into consideration in planning the semiconductor package, and therefrom the substrate material or composite is required to have a high thermal conductivity.

Specifically, the substrate is required to have a thermal expansion coefficient which is near to that of the chip mounted thereon and also to have a satisfactory thermal conductivity.

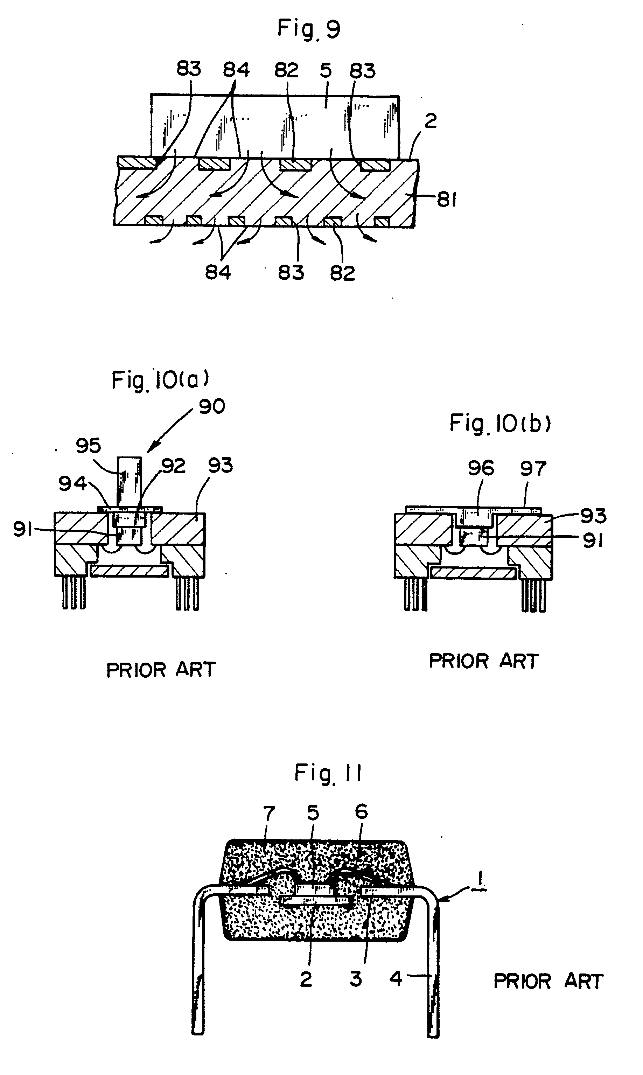

As one conventional semiconductor package, the package (90) having the construction as shown in Fig. 10-a is known, where Mo material (92) having a thermal expansion coefficient which is near to that of chip (91) is brazed and laminated with Kovar alloy material (94) having a thermal expansion coefficient which is near to that of alumina material (93) constituting the package substrate. The (91) chip is mounted on the Mo material (92), the chip being connected to the package substrate via the Kovar alloy material (94). A heat dissipating fin (95) is attached to the Kovar material (94).

In the said construction of figure 10(a), although the danger of peeling or cracking is small because the alumina material (93) and Kovar alloy material (94) each have a similar thermal expansion coefficient, there is a problem in the obtaining of sufficient heat-dissipation, even with the provision of the heat-dissipation, even with the provision of the heat dissipating fin (95) since the material that controls heat-dissipation is the Kovar alloy material (94) which has a relatively low thermal conductivity.

Under this situation, clad boards as well as composites for heat sinks, such as composites of Cu-Mo or Cu-W alloy, have been proposed as materials capable of satisfying the possibly conflicting requirements of having good conformity with the thermal expansion coefficient of chips while having high thermal conductivity.

As a clad board for heat sinks, a laminate material comprising a copper sheet and Invar alloy (36Ni-Fe alloy) sheet has been used. Copper has a large thermal expansion coefficient though having a good thermal conductivity, and in order to depress such high thermal expansion coefficient, Invar alloy is laminated to copper under pressure in the construction of such a clad board, whereby the longitudinal thermal expansion of the board is made conformable to the chip to be mounted thereon.

Where Invar alloy sheets are laminated on both surfaces of copper sheet under pressure to give a sandwich structure, warping by temperature elevation may be prevented.

Although the clad board of such a type could have the same thermal expansion coefficient as the chip to be mounted thereon, the thermal conductivity of the board in the thickness direction is not always sufficient since it has Invar alloy, as has the construction previously described with reference to Fig.10-a.

Cu-Mo or Cu-W alloy substrate is made of a composite of Cu and Mo or W, which is prepared by sintering and Mo or W powder having nearly the same thermal expansion coefficient as the chip to be mounted on the substrate to give a sintered sheet having a large porosity and then either a fused copper is applied thereto (Japanese Patent Application, Publication No. 59141247 dated August 13, 1984); or it is prepared by sintering an Mo or W powder and a copper powder (Japanese Patent Application, Publication No. 62-294147 dated December 21, 1987).

Referring to Fig. 10-b, which shows a semiconductor package, the composite substrate (96) has flanges (97) connected with alumina material (93) to constitute the package, the flanges extending on both opposite sides of a silicon chip (91) mounted on the substrate and heat dissipation is effected from the said flanges.

Although the said composites have fairly satisfactory performance and characteristics with respect to thermal expansion coefficient and thermal conductivity, the component must be machined after slicing so as to obtain the determined dimension, Mo and W each having a high density and being heavy. Such machine working costs a lot and the yield is poor. In addition, the dispersion of the thermal conductivity of the material is noticeable because of the structure of the composite, while additionally the mechanical shapability thereof is poor. Accordingly, the manufacture of such composites is problematic in itself.

In a resin-sealed semiconductor package of another type, the conformity of the thermal expansion coefficient and the heat-dissipation property in the chip, resin and lead frame must also be taken into consideration, like the above-mentioned ceramic package-containing semiconductor package.

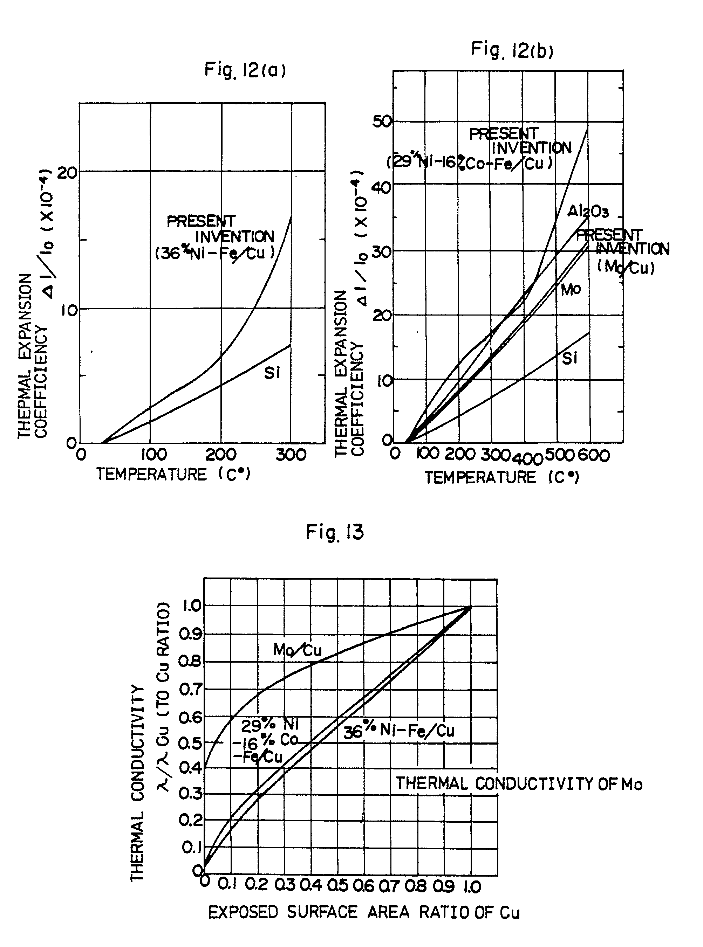

In a further prior art construction of resin-sealed semiconductor package, as shown in Fig.11, the lead frame is not only an electrically connecting line to other components, by it also has an important role as a conduit for the release of heat generated within the chip.

In this semiconductor package, a chip (5) is mounted on an island (2) formed in the center part of a lead frame (1) and is fixed thereon with a brazing material, adhesive or solder, while it is electrically connected to an inner lead portion (3) via a bonding wire (6) and is encased in resin (7).

The heat generated in the chip reaches a lead (4) of the lead frame (1) via island (2), resin (7) and inner lead portion (3) in order and is then dissipated outwards.

Accordingly, the lead frame (1) is desired to be made of a material having a high thermal conductivity so that it may give good outward dissipation of the heat generated in the chip.

On the other hand, peeling of the chip (5) from the island (2) at the interface therebetween and cracking of the resin (7) would be caused by the differences of thermal expansion coefficient between the chip (5), the sealant resin (7) and the lead frame (1). In order to prevent such peeling or cracking, good conformity of thermal expansion betweenthe chip (5), resin (7) and lead (1) is indispensible.

As mentioned above, Ni-Fe type alloys having a low thermal expansion coefficient, such as 42% Ni-Fe, have heretofore been used in many cases for manufacturing lead frames for semiconductor packages, in view of the conformity of the thermal expansion coefficient of the alloys with chips.

However, as Ni-Fe type alloys have a poor thermal conductivity, the lead frame made of such alloys could not have a heat-dissipation sufficient to satisfy present requirements.

In addition, the difference of thermal expansion between the chip and sealant resin is extremely large. Accordingly, even if the conformity of the thermal expansion coefficient is satisfactory between the lead frame and the chip, the conformity between the lead frame and the resin is poor so that it is difficult to completely prevent the cracking of the sealant resin.

As another example, a semiconductor package having a lead frame of a copper alloy with a good thermal conductivity has been proposed in view of ability to dissipate heat.

However, the conformity of thermal expansion coefficients between copper alloy and chips is poor so that peeling of the chip from its island at the adhering interface therebetween could not be prevented. Accordingly, stable and highly reliable semiconductor packages of the type could not be produced by mass production on an industrial scale up to the present.

## SUMMARY OF THE INVENTION

One object of the present invention is to provide a heat-conductive composite which may have a desired thermal expansion coefficient in accordance with the use thereof.

Another object of the present invention is to provide a heat-conductive composite which may have not only a desired thermal expansion coefficient but also a desired thermal conductivity by effectively incorporating a metal having a high thermal conductivity thereinto.

Specifically, a further object of present invention is to provide a composite which has an excellent conformity of thermal expansion coefficient with the chip to be mounted thereon in the manufacture of a semiconductor package and additionally has a high thermal conductivity.

Still another object of the present invention is to provide a substrate (heat sink) for a semiconductor package which has excellent workability and machinability and does not require slicing in the actual manufacture and which can be prepared at a low cost.

Still another object of the present invention is to provide a composite for lead frames which has an excellent conformity of thermal expansion coefficient with chips and sealant resins, which has an excellent thermal conductivity, and which may efficiently dissipate heat generated in chips during use.

Still another object of the present invention is to provide a composite for lead frames which has an excellent manufacturing reproducibility for industrial scale mass-production.

Additionally, a further object of the present invention is to provide various kinds of methods for producing the composites of the invention.

In order to attain the said objects of ensuring both the conformity of thermal expansion coefficient and the ability to dissipate heat and of improving the manufacture efficiency, the present inventors made various investigations and, as a result, have found that a heat-conductive composite having predetermined or desired thermal expansion coefficient can be obtained for example by laminating and integrating a metal sheet of high thermal expansion and a metal sheet of low thermal expansion by exposing the metal sheet of high thermal expansion through through-holes formed in the metal sheet of low thermal expansion and selecting the ratio of the thicknesses of the two metal sheets.

Additionally, the inventors have found that a heat-conductive composite having a desired thermal conductivity can further be obtained by using a metal which a high thermal conductivity such as Cu or Cu alloy as the said metal sheet of high thermal expansion and selecting the surface area ratio of the metal with a high thermal conductivity to be exposed to the main surface of the said metal sheets. It has therefore been found that the above-mentioned problems in the prior art may be overcome by the present invention.

Specifically, in accordance with the present invention there is provided a heat-conductive composite comprising a metal sheet of relatively high thermal expansion at least one main surface of which is bonded to a metal sheet of relatively low thermal expansion having a number of through-holes in the direction of the thickness, in which a part of the metal of high thermal expansion is exposed at the level of the exposed surface of the metal sheet of low thermal expansion.

As another aspect of this invention, there is provided a heat-conductive composite comprising a metal sheet of relatively low thermal expansion having a number of through-holes in the direction of the thickness and metal parts of relatively high thermal expansion filling the through-holes of the said metal sheet of lower thermal expansion, the both main surfaces of the metal parts of high thermal expansion filling the through-holes of the metal sheet of low thermal expansion being exposed at the level of the surfaces of the metal sheet of low thermal expansion.

As another aspect of the present invention, there is further provided a method for preparing a heat-conductive composite material, wherein a metal sheet of relatively high thermal expansion is laminated by pressure welding or forging to at least one main face of a metal sheet of lower thermal expansion having a number of through-holes in the direction of the thickness whereupon a part of the metal sheet of high thermal expansion is exposed out to the surface of the metal sheet of low thermal expansion through the through-holes of the metal sheet of low thermal expansion.

As still another aspect of the present invention, there is also provided a method for preparing a heat-conductive composite wherein a metal sheet of relatively high thermal expansion is laminated on one main surface of a metal sheet of low thermal expansion having a number of through-holes in the direction of the thickness and integrated by pressure welding or forging whereupon a part of the metal sheet of high thermal expansion is exposed out to the opposite main surface of the metal sheet of low thermal expansion through the through-holes thereof and level with the said surface, and the metal sheet of high thermal expansion as previously laminated and integrated with one main surface of the metal sheet of low thermal expansion is removed.

BRIEF DESCRIPTION OF THE DRAWINGS

Figs.1 to 6 are perspective diagrammatic views each showing an embodiment of heat-conductive composite according to the present invention.

Fig. 7 and Fig. 8 are perspective diagrammatic views each showing examples of a method for preparing a heat-conductive composite according to the present invention.

Fig. 9 is a sectional view to explain the heat-dissipation effect of the lead frame prepared by the use of a heat-conductive composite of the present invention.

Figs. 10a and 10b are each an outline view of a known semiconductor package where a ceramic is used as the package of semiconductor chip.

Fig. 11 is an outline view of a known semiconductor package where a resin is used as the package of semiconductor chip.

Figs 12a and 12b illustrate "thermal expansion rate/temperature" curves to show the thermal expansion characteristics of three heat-conductive composites of the present invention.

Fig. 13 indicates three "thermal conductivity/exposed surface area ratio of Cu" curves to show the thermal conductivity characteristic of three heat-conductive composites of the present invention.

DESCRIPTION OF THE PREFERRED EMBODIMENTS

In accordance with the present invention, the materials and shapes of the metal sheet of high thermal expansion and the metal sheet of low thermal expansion are selected in accordance with the use of the product. For instance, the heat-conductive composite having the particular construction of the present invention may have a desired thermal expansion coefficient at any point in the range of the values of the intrinsic thermal expansion coefficients of the respective metal sheet of high thermal expansion and metal sheet of low thermal expansion, by properly selecting the ratio of the thicknesses of the respective metal sheets to be laminated and integrated together to construct the said heat-conductive composite.

Accordingly, the metal sheet of high thermal expansion and the metal sheet of low thermal expansion for use in the present invention are not always required to have a large difference therebetween but any combination of different metal sheets each having a somewhat different thermal expansion coefficient from each other may be employed. Especially in view of the means of manufacturing the composite by pressure welding or forging, which will be explained in detail hereunder, the metal sheet of high thermal expansion is preferably made of a material having a high ductility and flexibility, such as Cu, Cu alloys, Al, Al alloys or steel.

For instance, the conventional semiconductor chip is required to have a thermal expansion coefficient ($\alpha$) of from $4 \times 10^{-6}/^{\circ}C$ to $9 \times 10^{-6}/^{\circ}C$, preferably from $5 \times 10^{-6}/^{\circ}C$ to $8 \times 10^{-6}/^{\circ}C$, at room temperature to $900^{\circ}C$ in order that it is not influenced by thermal strain.

The sealant resin is required to have a thermal expansion coefficient ($\alpha$) of from $10 \times 10^{-6}/^{\circ}C$ to $20 \times 10^{-6}/^{\circ}C$, more preferably from $14 \times 10^{-6}/^{\circ}C$ to $19 \times 10^{-6}/^{\circ}C$, at room temperature to $900^{\circ}C$ in order that it is not influenced by thermal strain.

Although constructions of various kinds could be proposed for attaining the thermal expansion coefficient falling within the said ranges, the object may easily be attained by effectively combining the materials which are widely used in this technical field.

For instance, as one preferred embodiment, a combination comprising metal sheet of low thermal expansion, which has a mean thermal expansion coefficient of $10 \times 10^{-6}/^{\circ}C$ or less at a temperature ranging from $30^{\circ}C$ to $200^{\circ}C$, and a metal sheet of high thermal expansion, which has a mean thermal expansion coefficient of more than $10 \times 10^{-6}/^{\circ}C$ at a temperature ranging from $30^{\circ}C$ to $200^{\circ}C$, can be employed for preparing the heat-conductive composite of the present invention.

More specifically, the heat-conductive composite comprises Cu or a Cu alloy as the metal of high thermal expansion and an Ni-Fe alloy containing from 30 to 50% by weight of Ni as the metal of low thermal expansion. As another preferred embodiment, there is mentioned a heat-conductive composite comprising of Cu or a Cu alloy as the metal of high thermal expansion and a Ni-Co-Fe alloy containing from 25 to 35% by weight of Ni and from 4 to 20% by weight of Co as the metal of low thermal expansion, which material also has the same effect.

As the case may be Mo or W may be employed as the metal of low thermal expansion in accordance with the use of the heat-conductive composite.

For good heat dissipation a material having a high thermal conductivity is preferably used as the said sheet of high thermal expansion. In order to satisfy present requirements in this technical field, it is desired at least to use as metal with a high thermal conductivity one which has a thermal conductivity of 140 W/m.K or more at 20°C. That is to say, satisfaction of at least the above-mentioned condition is necessary so as to obtain the same or better thermal characteristics as or than the thermal conductivity of an Mo substrate which is most used as a heat sink at present. As the material which satisfies the said condition, Al, Au and other various kinds of alloys may be selected, but Cu or Cu alloys are most preferred as they have a high thermal conductivity and are low-priced.

In the construction of the heat-conductive composite material of the present invention, although the shape and the arranged condition of the metal part of high thermal expansion to be arranged in the metal sheet of low thermal expansion are not specifically defined but may be anyone of a desired form in accordance with the method of manufacturing the material, the distance between the through-holes is advantageously thin and narrow for the purpose of reducing the dispersion of the products, and the distance is generally 3 mm or less, preferably 1 mm or less.

The through-holes to be formed in the metal sheet of low thermal expansion may be holed not only by mechanical working such as press-punching but also by chemical processing such as etching. Regarding the shape of the through-holes, the section in the thickness direction is not limited to only a straight one but may be a tapered one. In the latter case, introduction of the metal of the high thermal expansion into the through holes is facilitated and the junction strength may be enhanced. Regarding the shape of the exposed part of the metal of high thermal expansion, the shape is not limited to only a circular one but it may be any one of other various shapes of ovals, polygons or the like.

In particular, in the heat-conductive composite of the present invention, it has been confirmed that the surface area ratio of the metal of high thermal expansion to be exposed at the surface of the metal sheet of low thermal expansion is generally preferably from 20% to 80% in order to obtain the sufficient thermal conductivity necessary for a substrate (heat sink), though it would vary in accordance with the metal of low thermal expansion and the metal of high thermal expansion as well as the shapes and sizes thereof, and a desired effect may be obtained in such range.

It is sometimes desired that the heat-conductive composite material of the present invention is coated with Ni plating in use thereof, for the purpose of improving the brazability, improving the corrosion-resistance and further improving the Au-platability, Au-plating being often employed in the manufacture of semiconductor packages. For this, the heat-conductive composite material obtained in accordance with the present invention may be plated on the necessary parts such as the complete surface, the two main surfaces, one main surface or the side edges, as desired. In particular, in the construction where the metal part of high thermal expansion is filled only in the insides of the through-holes, plating on the main surface is preferred for the purpose of further improving the sealed condition in the direction of the thickness of the laminate. It may also be preferred to coat a Cu-plating as a subbing layer below the Ni-plating.

As a heat-conductive composite of the present invention has its own intrinsic thermal expansion coefficient and thermal conductivity, two or more of them each having different characteristics may be laminated together to give a heat-conductive composite of yet different kind which has any desired thermal expansion coefficient and thermal conductivity charateristics.

In the heat-conductive composite of the present invention, the conditions of the surface area ratio of the metal part of high thermal expansion as exposed out to one main surface, and the material and thickness of the metal sheet of low thermal expansion of one main surface may be made different from those of the other main surface, whereby the thermal characteristics of each main surface may be made nearer to the desired values.

In accordance with the present invention, therefore, various modifications may easily be effected, as for example illustrated in detail in the examples to follow hereunder. For instance, there are mentioned a structure where a metal sheet of high thermal expansion is laminated to metal sheets of low thermal expansion on the both main surfaces thereof, a structure where a metal sheet of high thermal expansion is laminated to a metal sheet of low thermal expansion on one main surface thereof, a structure where a metal sheet of high thermal expansion is strip-wise laminated to metal strips of low thermal expansion on the necessary parts of the both surfaces thereof, and a structure where the laminate thus prepared is further worked so as to vary the arrangement, shape and dimension, of the metal of high thermal expansion as exposed at the surface of the metal sheet of low thermal expansion. Selecting the structures of the said various kinds, various modifications may be made to the heat-conductive composite of the present invention.

Various methods are proposed for manufacturing the heat-conductive composite of the present invention explained hereinbefore, by industrial scale mass-production.

As one preferred embodiment for efficiently providing heat-conductive composite having stable characteristics, a known compressing and rolling technique may be employed where a number of through-holes are pierced through a sheet of metal of low thermal expansion in the necessary positions, and thereafter that sheet is cold-rolled together with a sheet of metal of high thermal expansion and then subjected to treatment with a diffused heat thereby to improve the bond between the two sheets.

The reduction ratio and other conditions are defined in accordance with the materials, shapes and dimensions of the metal sheet of low thermal expansion and the metal sheet of high thermal expansion, and the reduction ratio which is generally employed in the present invention is from 40% to 80%. In order to improve the bond between the metal sheet of low thermal expansion and the metal sheet of high thermal expansion, the two metal sheets may be annealed prior to pressure welding, and after the surfaces to be laminated are wire-brushed, the two metal sheets are integrated by pressure welding together. Then the thus integrated laminate is subjected to diffusion annealing, generally at 500°C to 1050°C for 1 minute to 10 minutes or so.

Where the two metal sheets are thick and could hardly be laminated and integrated by pressure welding, the two metals may be forged and then laminated and integrated.

Especially when the metal of high thermal expansion is a metal having a low melting point, such as Cu, Al or the like, the said metal may be integrated with a metal sheet of low thermal expansion having through-holes in the thickness direction by casting.

In one structure of the heat-conductive composite material of the present invention where the metal of high thermal expansion is arranged only in the inside of the through-holes of the metal sheet of low thermal expansion, the parts of the metal of high thermal expansion as project out of the through-holes on the main surface of the heat-conductive composite material prepared by the above-mentioned manufacture method may be removed with ease by means of a known surface-grinding method or the like.

Now, one embodiment of the present invention where copper sheet is used as the metal sheet of high thermal expansion and Kovar alloy (Fe-Co-Ni alloy) sheet is used as the metal sheet of low thermal expansion will be explained hereunder.

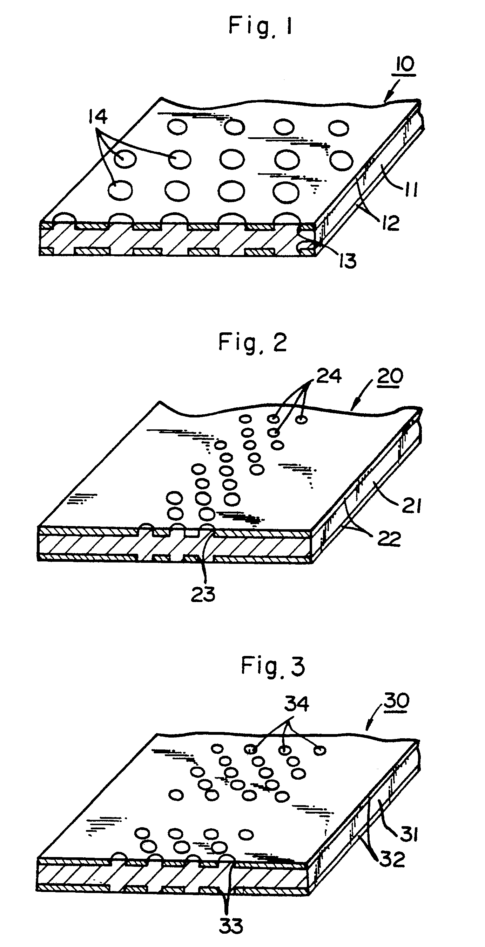

Figs. 1 through 3 are referred to, where heat-conductive composites (10), (20) and (30) are composed of copper sheets (11), (21) and (31), respectively, both surfaces of which have been laminated by pressure-welding with Kovar sheets (12), (22) and (32), respectively, each having a number of through-holes.

The composite (10) of Fig. 1 has a construction such that the surfaces (14) of the Cu sheet exposed at the surface of Kovar sheet (12) through the holes (13) are uniformly dispersed across the whole of both main surfaces of the cladding Kovar sheets (12).

The composite (20) of Fig. 2 has a construction such that the surfaces (24) of the copper sheet exposed at the surface of Kovar sheet (22) through the through-holes (23) are strip-wise dispersed across the two main surfaces of the cladding Kovar sheets (22).

The composite (30) of Fig. 3 has a construction such that surfaces (34) of the copper sheet exposed at the surface of Kovar sheet (32) through the through-holes (33) are discontinuously and group-wise dispersed in the longitudinal direction on the two main surfaces of the cladding Kovar sheets.

In any of these constructions, the thickness of each Kovar sheet to be pressure-welded to a surface of the copper sheet (11), (21) or (31) as well as the dispersed state of the exposed surfaces (14), (24) or (34) of the copper sheet may be selected, whereby the thermal characteristics of the main surfaces may be adjusted as desired.

In particular, in the heat-conductive composite having the construction of Fig. 2 or Fig. 3, the exposed surfaces of the copper sheet are made dispersed on the two surfaces at locations where chips are to be mounted in the manufacture of lead frames, whereby efficient heat-dissipation is possible in the resulting lead frames.

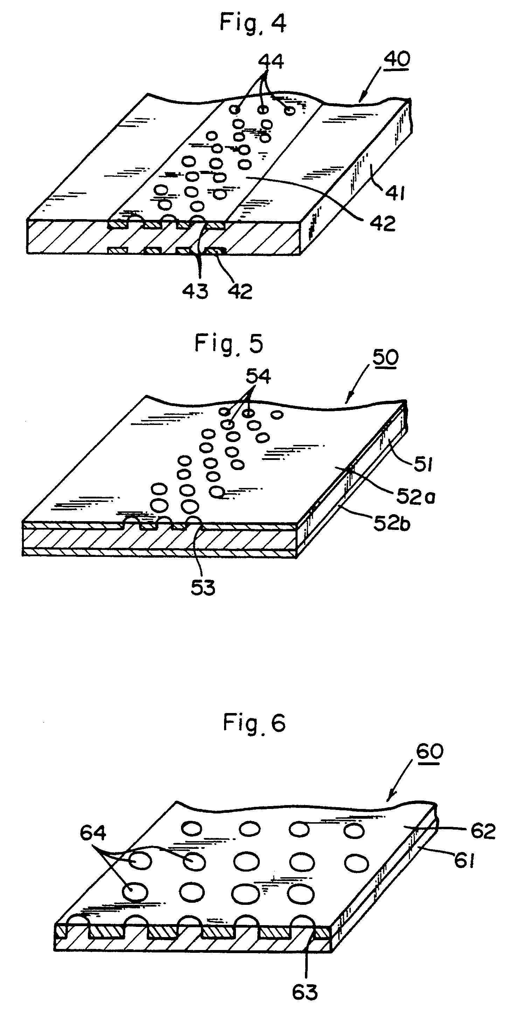

Fig. 4 showing a heat-conductive composite (40) is now referred to. In Fig. 4 Kovar sheets (42) have been strip-wise pressure-welded on the two surfaces of a copper sheet (41) along only its center part which is to be positioned in the sealant resin in the manufacture of lead frames. In this construction, copper surfaces (44) are exposed arranged in the desired parts through the through-holes (43). Where the composite (40) of that construction is used in the manufacture of a lead frame, a chip is mounted on the Kovar part (42) pressure-welded on the center part of the copper sheet (41) and the copper part (41) near the pressure-welded Kovar part (42) is sealed with a resin along with the chip. The two edges of the copper sheet (41) are to be positioned outside the sealant resin. Accordingly, not only may thermal expansion conformity between the chip and the Kovar part (42) and as between the sealed copper sheet part (41) and the sealant resin be attained, but also excellent heat-dissipation may be attained by the lead part made of only the copper sheet (41) which is positioned outside the sealant resin, in that construction.

Fig. 5 showing a heat-conductive composite (50) is now referred to. In Fig. 5 Kovar sheets (52a) and (52b) have been pressure-welded to the two surfaces of the copper sheet (51), like the embodiments of Fig. 1 to Fig. 3. In this construction, however, through-holes (53) have been formed only in one Kovar sheet (52a), whereby the exposed surfaces (53) of the copper sheet are arranged in the necessary parts of only one main surface.

In Fig. 6 is shown a heat-conductive composite material (60) where a Kovar sheet (62) having through-holes (63) has been pressure-welded to only one main surface of the copper sheet (61). Exposed surfaces (64) of the copper sheet are shown dispersed over the whole surface of the material (60), though they could alternatively be strip-wise or group-wise dispersed.

In the constructions of Fig. 5 and Fig. 6, presence or absence of the exposed surfaces of the copper sheet as well as presence or absence of the Kovar sheet may freely be defined, whereby the difference in the thermal characteristics between the two main surfaces of the resulting composite may be made much larger.

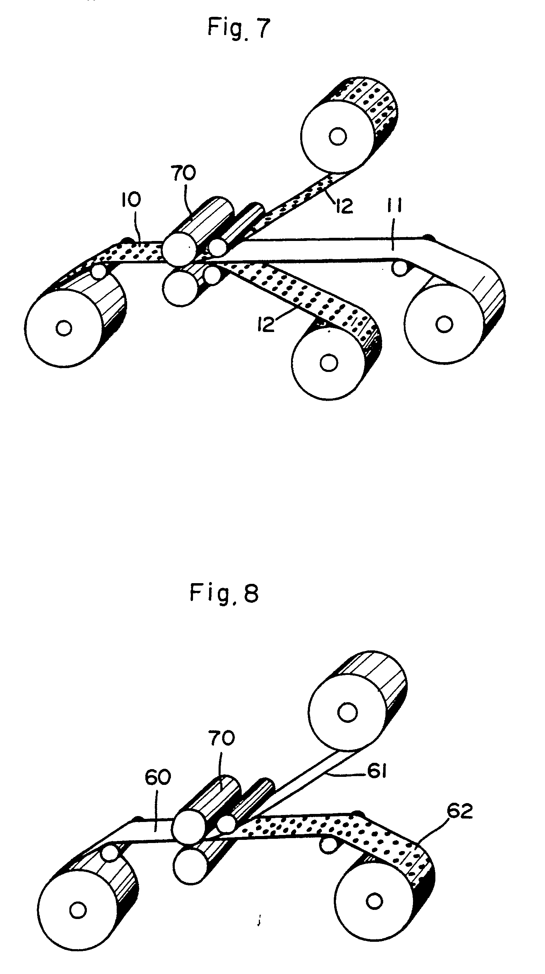

A method for preparing the heat-conductive composite material (10) having the construction of Fig. 1 will be explained, with reference to Fig. 7. A pair of Kovar sheets (12) and (12) are previously punched by pressing whereby a number of small holes are punched therethrough, for example, in a net-like pattern. The thus punched sheets are then annealed and surface-treated and thereafter wound onto separate reels.

A reel of copper sheet (1) having a selected size and thickness is unwound so that the copper sheet (11) is sandwiched between the two punched Kovar sheets (12) as they are unwound from their respective reels. The patterns of the holes punched with the two sheets may be the same or different The thus formed sandwich is passed between pressure rolls (70) where it is pressure-welded to form the composite laminate (10).

In the rolling process, copper penetrates into the through-holes (13) of the Kovar sheets (12), as shown in Fig. 1, whereby exposed surfaces (14) of the copper sheet (11) are partly arranged and formed in the necessary portions of the Kovar sheet (12).

Next, the resulting laminate is annealed for diffusion treatment and, as a result, the bond between the layers may be much improved.

For the purpose of preparing the heat-conductive composite (6) shown in Fig 6, one Kovar sheet (62) and one copper sheet (61) are processed in accordance with the same steps as Fig. 7, as shown in Fig. 8.

The thus prepared heat-conductive composite can be worked into a lead frame by a known method and then constructed to give a semiconductor package as shown in Fig. 9, where the portion to have the chip (5) mounted thereon is substantially coated with the Kovar sheet (82) and therefore the thermal conformity between the chip (5) and the sheet (82) is good. Further, efficient heat dissipation may be effected via the surfaces (84) of copper (81) as exposed through the through-holes (83) of the Kovar sheet (82) and thus the heat from the chip may be well dissipated to the outside of the package via the said island, resin, sheet and lead (not shown).

In addition, the thickness of the Kovar sheet (82) and the surface area ratio of the exposed surfaces (84) of copper (81) may properly be adjusted in accordance with the thermal expansion coefficient of the sealant resin, whereby conformity of thermal expansion coefficients between the sealant resin and the lower surface of the metal sheet may be well improved.

Where the heat-conductive composite thus prepared is worked into a substrate (heat sink) and then constructed to give a semiconductor package by a known method, the thermal conformity with the chip is good and the efficiency of the package is also good. In addition, it was also confirmed that the heat generated in the package could well be released out to the outside of the package.

In particular, when rolling and pressure-welding are employed in preparing the heat-conductive composite, the composite may be obtained in a determined dimension and the composite does not therefore need to be subjected to any complicated working operation such as slicing or the like for finishing the composite to the determined thickness. Accordingly, the composite may be obtained at a low manufacture cost and additionally it has an excellent cutting-workability. The composite therefore has an advantage that it may easily be worked in any desired dimension in accordance with the package substrate or chip.

The following examples are intended to illustrate the present invention in more detail but not to limit it in any way.

EXAMPLE 1

A number of through-holes each having a hole diameter of 0.8 mm were punched in an Invar sheet (36Ni-Fe alloy) having a thickness of 0.5 mm and a width of 30 mm, at intervals of 0.8 mm between the holes. The sheet was then annealed at $900°C$ and then subjected to wire-brushing. The Invar sheet used had a mean thermal expansion coefficient of $2.5 \times 10^{-6}/°C$ at $30°C$ to $200°C$.

On the other hand, a Cu sheet having a thickness of 1.0 mm and a width of 30 mm was analogously annealed and subjected to wire-brushing. The Cu sheet used had a mean thermal expansion coefficient of $17.2 \times 10^{-6}/°C$ at $30°C$ to $200°C$.

The said Invar sheet and Cu sheet were welded under pressure by the use of a cold pressure-welding machine shown in Fig. 8 to obtain a composite sheet having a thickness of 0.5 mm. The reduction ratio was 67%. During the cold pressure-welding, Cu penetrated into the through-holes of the Invar sheet, and a composite sheet of Fig. 6 was obtained where a number of Cu spots were dotwise exposed at the Invar surface.

The composite sheet was subjected to diffusion annealing at $800°C$ for 5 minutes to improve bonding. The surface area ratio of copper exposed at the surface of the Invar side in the heat sink thus obtained was about 25%. This had a thermal conductivity of 150 W/m.K in the direction of the thickness and had a thermal expansion coefficient of $4.5 \times 10^{-6}/°C$ at $30°C$ to $200°C$ in the Invar surface side.

EXAMPLE 2

A number of through-holes each having a hole diameter of 1.0 mm were punched in a pair of Kovar sheets (29Ni-16C0-Fe alloy) each having a thickness of 0.3 mm and a width of 30 mm, at intervals of 0.5 mm between the holes. The sheets were then annealed at $900°C$ and then subjected to wire-brushing. The Kovar sheets used had a mean thermal expansion coefficient of $5.2 \times 10^{-6}/°C$ at $30°C$ to $200°C$.

On the other hand, a copper sheet having a thickness of 1.2 mm and a width of 30 mm was analogously annealed and subjected to wire-brushing. The Cu sheet used had a mean thermal expansion coefficient of $17.2 \times 10^{-6}$ at $30°C$ to $200°C$.

The said Kovar sheets and copper sheet were welded under pressure by the use of a cold pressure-welding machine as shown in Fig. 7 to obtain a composite sheet having a thickness of 0.7 mm. The reduction ratio was 61%.

During welding, copper penetrated into the through-holes of the Kovar sheets, and a composite of Fig. 1 was obtained where copper spots were exposed at predetermined portions of the surfaces of the Kovar sheets.

The composite material was subjected to diffusion annealing at $800°C$ for 5 minutes to improve bonding.

The Cu-exposed portions on the main surfaces of the final product were in the form of an oval having the major axis in the roller direction, and the intervals between the holes each were 1.0 mm in the rolled direction (or in the longitudinal direction). The surface area ratio of the Cu-exposed portions was about 35%.

The composite thus obtained had a thermal conductivity of 300 W/m.K in the direction of the thickness and had a mean thermal expansion coefficient of $8 \times 10^{-6}/°C$ at $30°C$ to $200°C$ in each main surface.

The composite was further cold-rolled to a thickness of 0.25 mm and then worked into a lead frame by a known method. This was thereafter formed into a semiconductor package, which was free from troubles of peeling between the chip and the island in the adhered interface therebetween or cracking of the sealant resin. In addition, it was further confirmed that the lead frame had a good heat-dissipating property like the conventional lead frame made of a copper alloy.

EXAMPLE 3

Thermal expansion characteristics of other heat-conductive composites (thickness : 0.7mm) obtained by using 36Ni-Fe sheet or Mo sheet as a metal sheet of low thermal expansion and Cu sheet as a metal sheet of high thermal expansion in accordance with the same method as Example 2 as well as those of the heat-conductive composite material (thickness : 0.7mm) obtained in Example 2 were measured, and the results were shown in Figs. 12-a and 12-b, where the ordinate indicates thermal expansion rate and the abscissa indicates temperature.

From Fig. 12-a, it is ascertained that the heat-conductive composite material of the present invention comprising 36Ni-Fe sheet and Cu sheet has a similar thermal expansion characteristic to Si in the temperature range (up to $200°C$) at which semiconductor packages are generally operated.

From Fig. 12-b, it is ascertained that the heat-conductive composite material of the present invention comprising 29Ni-16Co-Fe sheet and Cu sheet has a similar thermal expansion characteristic to $Al_2O_3$ which is frequently used in semiconductor packages, and it is therefore believed that the articles obtained by brazing the two would almost be free from peeling or cracking therebetween.

From Fig. 12-b, it is also ascertained that the heat-conductive composite material of the present invention comprising Mo sheet and Cu sheet has a very similar thermal expansion coefficient to simple Mo material. In particular, the former heat-conductive composite material of the present invention has a much improved thermal conductivity over the sample Mo material, which will be clarified in the following Example 4, and the excellent effect of the present invention is obvious from the result.

## EXAMPLE 4

In variations of forming the composites of Example 3, the hole diameter of the through-holes to be formed in the metal sheet of low thermal expansion and the intervals between the through-holes were varied, whereupon the relation between the variation of the exposed surface area ratio of the metal of high thermal expansion of the respective heat-conductive composites and the thermal conductivity thereof was determined. The results are shown in Fig. 13, where the ordinate indicates thermal conductivity and the abscissa indicates exposed surface area ratio of Cu.

From Fig. 13, it is confirmed that all the heat-conductive composites may have any desired thermal conductivity selectable from a broad range by varying the surface area ratio.

Specifically, a better thermal conductivity could be obtained when the exposed surface area of the metal of high thermal expansion is broader. However, in consideration of the workability of the composite, the exposed surface area ratio of Cu is generally preferably selected within the range from 20% to 80%. In particular, when the composite is used for the manufacture of a heat sink of a semiconductor package, the surface area thereof is desirably 35% or more for the case comprising 36Ni-Fe sheet and Cu sheet or is desirably 30% or more for the case comprising 29Ni-16Co-Fe sheet and Cu sheet.

As was already explained in the previous Example 3, the heat-conductive composite comprising Mo sheet and Cu sheet was confirmed to have a noticeably improved thermal conductivity over the simple Mo article.

While the invention has been described in detail and with reference to specific embodiments thereof, it will be apparent to one skilled in the art that various changes and modifications can be made therein without departing from the spirit and scope thereof.

In particular, the invention includes any heat conductive composite characterised in that such composite comprises a sheet of a first metal having a first coefficient of thermal expansion which sheet is provided with a plurality of holes which are filled with a second metal bonded to the first and having a different coefficient of thermal expansion.

Preferably said second metal has a higher coefficient of thermal expansion than the first and forms at least one thermally conductive bridge extending through the entire thickness of the composite.

Advantageously such heat conductive composite comprises at least one sheet of said first metal laminated to at least one sheet of said second metal.

## Claims

1. A heat-conductive composite comprising a metal sheet of relatively high thermal expansion at least one main surface of which is bonded to a metal sheet of relatively low thermal expansion having a number of through-holes in the direction of the thickness, in which a part of the metal of high thermal expansion is exposed at the level of the exposed surface of the metal sheet of low thermal expansion.

2. A heat-conductive composite comprising a metal sheet of relatively low thermal expansion having a number of through-holes in the direction of the thickness and metal parts of relatively high thermal expansion filling the through-holes of the said metal sheet of lower thermal expansion, the both main surfaces of the metal parts of high thermal expansion filling the through-holes of the metal sheet of low thermal expansion being exposed at the level of the surfaces of the metal sheet of low thermal expansion.

3. A heat-conductive composite as claimed in claim 1 or 2, in which the metal sheet of low thermal expansion has a thermal expansion coefficient of $10 \times 10^{-6}/°C$ or lower at 30 °C to 200 °C and the metal sheet of high thermal expansion has a thermal expansion coefficient of higher than $10 \times 10^{-6}/°C$ at 30 °C to 200 °C.

4. A heat-conductive composite as claimed in claim 1 or 2, in which the metal sheet of high thermal expansion is a metal with a high thermal conductivity.

5. A heat-conductive composite as claimed in claim 4, in which the metal with a high thermal conductivity has a thermal conductivity of 140 W/m.K or more at 20 °C.

6. A heat-conductive composite as claimed in claim 1 or 2, in which the surface area ratio of the metal sheet of high thermal expansion as being exposed out to the surface of the metal sheet of low thermal expansion is from 20% to 80%.

7. A heat-conductive composite as claimed in claim 5, in which the metal with a high thermal conductivity is Cu or a Cu alloy.

8. A heat-conductive composite as claimed in claim 1 or 2, in which the metal sheet of high thermal expansion is Cu or a Cu alloy and the metal sheet of low thermal expansion is an Ni-Fe alloy containing Ni in an amount of from 30 to 50% by weight.

9. A heat-conductive composite as claimed in claim 1 or 2, in which the metal sheet of high thermal expansion is Cu or a Cu alloy and the metal sheet of low thermal expansion is an Ni-Co-Fe alloy containing from 25 to 35% by weight of Ni and from 4 to 20% by weight of Co.

10. A heat-conductive composite as claimed in claim 1 or 2, in which the metal sheet of high thermal expansion is Cu or a Cu alloy and the metal sheet of low thermal expansion is Mo.

11. A heat-conductive composite as claimed in claim 1 or 2, which has been coated by Ni-plating.

12. A heat-conductive composite prepared by laminating and integrating plural heat-conductive composite materials as claimed in claim 1 or 2 in the direction of the thickness.

13. A heat-conductive composite as claimed in claim 1 or 2, in which the through-holes formed in the metal sheet of low thermal expansion each have a tapered form.

14. A substrate (heat sink) for mounting a semiconductor chip thereon, which is made of the heat-conductive composite as claimed in any preceding claim.

15. A material for lead frame, which is made of the heat-conductive composite as claimed in any preceding claim.

16. A method for preparing a heat-conductive composite material, wherein a metal sheet of relatively high thermal expansion is laminated by pressure welding or forging to at least one main face of a metal sheet of lower thermal expansion having a number of through-holes in the direction of the thickness, whereupon a part of the metal sheet of high thermal expansion is exposed out to the surface of the metal sheet of low thermal expansion through the through-holes of the metal sheet of low thermal expansion.

17. A method for preparing a heat-conductive composite wherein a metal sheet of relatively high thermal expansion is laminated on one main surface of a metal sheet of low thermal expansion having a number of through-holes in the direction of the thickness and integrated by pressure welding or forging whereupon a part of the metal sheet of high thermal expansion is exposed out to the opposite main surface of the metal sheet of low thermal expansion through the through-holes thereof and level with the said surface, and the metal sheet of high thermal expansion as previously laminated and integrated with one main surface of the metal sheet of low thermal expansion is removed.

18. A method for preparing a heat-conductive composite as claimed in claim 16 or 17, in which the metal sheet of high thermal expansion is Cu or a Cu alloy and the metal sheet of low thermal expansion is an Ni-Fe alloy containing Ni in an amount of from 30 to 50% by weight.

19. A method for preparing a heat-conductive composite as claimed in claim 16 or 17, in which the metal sheet of high thermal expansion is Cu or a Cu alloy and the metal sheet of low thermal expansion is an Ni-Co-Fe alloy containing from 25 to 35% by weight of Ni and from 4 to 20% by weight of Co.

20. A method for preparing a heat-conductive composite as claimed in claim 16 or 17, in which the metal sheet of high thermal expansion is Cu or a Cu alloy and the metal sheet of low thermal expansion is Mo.

21. A method for preparing a heat-conductive composite as claimed in claim 16 or 17, in which the metal sheet of high thermal expansion is integrated with the metal sheet of low thermal expansion and then the resulting heat-conductive composite is coated by Ni-plating.

22. A heat conductive composite characterised in that such composite comprises a sheet of a first metal having a first coefficient of thermal expansion which sheet is provided with a plurality of holes which are filled with a second metal bonded to the first and having a different coefficient of thermal expansion.

23. A heat conductive composite according to claim 22 wherein said second metal has a higher coefficient of thermal expansion than the first and forms at least one thermally conductive bridge extending through the entire thickness of the composite.

24. A heat conductive composite according to claim 22 or 23, which comprises at least one sheet of said first metal laminated to at least one sheet of said second metal.

Fig. 1

Fig. 2

Fig. 3

Fig. 4

44    40

41

42

43  42

Fig. 5

54    50

51

52a

52b

53

Fig. 6

60

64    62

61

63

Fig. 7

Fig. 8

Fig. 9

Fig. 10(a)

PRIOR ART

Fig. 10(b)

PRIOR ART

Fig. 11

PRIOR ART

EP 0 392 109 A2

Fig. 12(a)

Fig. 12(b)

Fig. 13